Europäisches Patentamt

European Patent Office

Office européen des brevets

(19)

(11) Publication number: **0 200 500**
**A2**

(12) **EUROPEAN PATENT APPLICATION**

(21) Application number: **86303148.0**

(22) Date of filing: **25.04.86**

(51) Int. Cl.⁴: **G 11 C 11/24**

(30) Priority: **26.04.85 US 727709**

(43) Date of publication of application:
**05.11.86 Bulletin 86/45**

(84) Designated Contracting States:
**AT BE CH DE FR GB IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Chuang, Patrick T.**
**929 Old Town**
**Ct. Cupertino California(US)**

(72) Inventor: **Shu, Lee-Lean**
**204 Lane Tree**
**Ct. Milpitas California(US)**

(74) Representative: **Sanders, Peter Colin Christopher et al,**
**BROOKES & MARTIN High Holborn House 52/54 High**
**Holborn**
**London WC1V 6SE(GB)**

(54) CMOS memory bias systems.

(57) A biasing scheme for a CMOS memory array. The bit lines and dummy bit lines in the array are precharged to $V_{cc}/2$, where $V_{cc}$ is the externally supplied voltage level. The capacitor plates of the memory cells and dummy cells are biased to $V_{cc}/2$ and the N well is biased to $1.5 V_{cc}$. The biasing scheme reduces, or eliminates, the effects of precharge current spike, differential sense amp voltage reduction, sense level disturbance and charge injection. A bit line emulating bias voltage generator minimizes power dissipation.

EP 0 200 500 A2

Croydon Printing Company Ltd.

CMOS MEMORY BIAS SYSTEMS

The invention relates generally to IC CMOS, dynamic random access memories (DRAMS), and more particularly, to a voltage biasing scheme for a CMOS DRAM.

Recent advances in CMOS technology have allowed memory circuit designers to realize the power reduction inherent in CMOS design while achieving high density. However, as memory cell size decreases to allow for high density arrays, the susceptibility of alpha particle induced soft errors in the array increases. A CMOS DRAM utilizing P channel memory cells disposed in an N well formed in a P substrate significantly reduces this soft error susceptibility. Further, the P channel transfer gate of the memory cell contributes to a quiet background for charge storage in the memory cell storage.

Designs for CMOS DRAMS have been proposed in papers by Chwang, et al., entitled "A 70ns High Density CMOS DRAM," IEEE International Solid States Conference Proceedings, 2/23/83, p. 56; Kung, et al., entitled "A Sub-100ns 256 K DRAM in CMOS III Technology," 1984 IEEE International Solid States Circuits Conference Proceedings, pp. 278-279; and by Shimohigashi, et al., entitled "An N Well CMOS Dynamic RAM," IEEE International Solid States Circuits, Vol. SC-17, No. 2, April, 1982, pp. 344-348.

In each of these references, a particular bias scheme is proposed for the CMOS P channel memory. The bias voltages of importance include the word line voltage levels ($V_{WL}$), the bit line precharge voltage levels ($V_{BL}$), the capacitor plate voltage levels ($V_{CP}$), and the N well voltage level ($V_{NW}$). The selection of these voltage levels is critical to the performance of

2

the memory array. Among the problems inherent in a high density memory are precharge current spike and problems due to a change in the magnitude of the power supply voltage.

Prior to sensing the bit stored in a memory cell, the voltage state on both the bit line and the dummy bit line are equalized. This equalization requires a supply of charge to all the bit lines in the array and results in a large spike in the current either supplied or sunk by the bit line voltage reference.

Each memory array is coupled to an external power supply. Several problems related to bias voltage states are created during an excursion in power supply voltage levels known as voltage bumps. Among the more serious problems are charge injection, sense level disturbance, and reduction of the differential sense voltage state at the sense amplifier.

In the biasing schemes set forth in the above references either $V_{NW}$ and/or $V_{CP}$, and $V_{WL}$ are tied to the power supply voltage level, $V_{CC}$. During a $V_{CC}$ bump, the voltage level at the storage node of the memory cell changes due to capacitive coupling through the oxide layer separating the capacitor plate from the storage node and through the PN junction formed between the storage node and the N well. However, the magnitude of voltage change at the storage node does not equal the full magnitude of the voltage bump.

Charge injection occurs when the PN diode formed between the storage node and the N well is forward biased. For example, assume that the storage node is charged to an original $V_{CC}$ equal to 6V and that $V_{NW}$ is equal to $V_{CC}$. If $V_{CC}$ bumps down to 4V then the PN diode is forward biased and current flows from the storage node to the N well. Under certain conditions, this current will result in bipolar latchup.

Sense disturbance results when unselected cells storing charge ("1") leak charge into the bit lines thereby disturbing the pre-sense voltage state on the bit line. For example, if the voltage level at the storage node is 6V then the source voltage of the access transistor is 6V. The gate of the access transistor is tied to the word line so that the gate voltage is equal to $V_{WL}$ equal to 6V. If $V_{CC}$ bumps from 6 volts to 4 volts, then $V_{GS}$ for the access transistor is negative, the access transistor conducts, and charge leaks from the storage node to the bit line. This leaked charge changes the presensing voltage level on the bit line.

The sense amp is a cross-coupled latch that is triggered by the differential voltage developed on bit line and dummy bit line. The magnitude of this differential voltage is very small and any reduction in this magnitude would greatly impair the performance of the sense amp. A voltage bump usually results in a reduction in the magnitude of the differential sense amp voltage and accordingly reduces the accuracy of the sensing operation.

Therefore, a CMOS memory bias scheme that reduces, or eliminates, the problems of precharge current spike, charge injection, sense disturbance, and reduction of the differential sense voltage level is greatly needed by the semiconductor manufacturing industry.


The present invention comprises a CMOS biasing system for a CMOS memory circuit coupled to an external power supply voltage, $V_{CC}$. The system precharges bit line and dummy bit line to $V_{CC}/2$ prior to sensing. Preferably, an N well is biased at 1.5 $V_{CC}$ and the capacitor plates of the memory cells are biased at $V_{CC}/2$.

In a preferred embodiment, the CMOS memory includes K CMOS sense amps (SA), each coupled to a bit line, and a dummy bit line, with each bit line and dummy bit line coupled to M storage cells.

The memory cells are disposed in an N well formed in a P- doped silicon substrate. Each storage cell includes a first P region which functions as the storage node, a capacitor plate disposed above the storage node that is separated from the storage cell by an oxide layer, and a second P+ region coupled to a bit line or dummy bit line. The first and second P regions are separated by a channel being the region of the N well disposed between the first and second P regions. An access control gate is disposed over the channel and separated from the channel by an oxide layer. The first and second P regions, channel, and control gate form a P channel access transistor and the first P region and the capacitor plate form a storage capacitor having capacitance $C_{ST}$. The second P region function as a bit line junction.

The capacitor plates of all the storage cells are coupled to an on-chip bit line emulating $V_{CC}/2$ bias generator. The bit line/dummy bit line pair for each SA are coupled by a coupling transistor having its control gate coupled to a first external control signal.

According to one aspect of the invention, the bit line and dummy bit line are each coupled to the bit line emulating $V_{CC}/2$ bias generator by a biasing transistor network with the transistors in the network having their gates coupled to a second external control signal.

The bit line and dummy bit lines are coupled by the coupling transistor to precharge the line. Prior to precharge, the voltage state on one line of the bit line/dummy bit line pair is equal to $V_{CC}$ and the voltage state on the other line is equal to 0 as a result of a previous sense cycle. Thus, by coupling the bit line and dummy bit line, the voltage state on each line is precharged to about $V_{CC}/2$. Accordingly, very little current needs to be supplied by the bit line emulating $V_{CC}/2$ bias generator voltage to equalize the voltage on all the bit lines in the array. Thus, the large current spike resulting during standard precharge operations has been eliminated.

According to another aspect of the invention, the bit line/dummy bit line pair is precharged prior to initiation a sense cycle to allow the voltages on the lines to settle.

According to a still further aspect of the invention, the on-chip bit line emulating $V_{CC}/2$ bias generator contains circuitry to emulate the characteristics bit line/dummy bit line pair, the coupling transistor, biasing transistors and the transistors in the SA. This emulation causes the output of the bias generator to closely track the voltage on the bit line/dummy bit line pair that results from coupling the pair during precharge. Thus, when the bias generator is coupled to the bit line/dummy bit line pair little current is required to equalize the voltage level on the pair to the output of the bias generator. This is a significant advantage, because supplying current to the bit line/dummy bit line pairs in the array requires power. By minimizing the current supplied, the inherent low-power characteristics of CMOS technology are fully realized.

The bit line emulating $V_{CC}/2$ bias generator compensates for leakage currents through the bit line junctions, maintains the correct precharge level during a $V_{CC}$ bump to prevent signal loss, and biases the memory cell capacitor plates.

The inventors have discovered that tying $V_{CP}$ to $V_{CC}/2$ stabilizes the magnitude of the differential sense voltage during a voltage bump. Additionally, for a $V_{CP} = V_{CC}/2$ the magnitude of the sense disturbance is reduced to an insignificant level.

Charge injection problems are also greatly reduced in the present invention because $V_{NW}$ is equal to 1.5 $V_{CC}$.

Accordingly, a CMOS memory bias scheme embodying the present invention can reduce, or eliminate, the problems of current spike, reduction of the magnitude of differential sense amplifier voltage, sense level disturbance, and charge injection. Additionally, since the bit line/dummy bit line pair are precharged prior to the initiation of the sense cycle, access time is minimized. Further, the use of a bit line emulating bias generator minimizes power dissipation.

In the accompanying drawings, by way of example only:-

Fig. 1 is a circuit diagram of an embodiment of the present invention.

Fig. 2 is a timing diagram illustrating the operation of the embodiment of Fig. 1.

Fig. 3 is a cross sectional view of a P channel memory cell.

Fig. 4 is a circuit diagram of the cell depicted in Fig. 3.

Fig. 5A is a circuit diagram for a bit line emulating $V_{CC}/2$ bias generator.

Fig. 5B is a schematic diagram of the bit line emulating capacitor.

Fig. 6 is a timing diagram illustrating the operation of the circuit of Fig. 5.

The present example is a CMOS memory cell bias scheme.

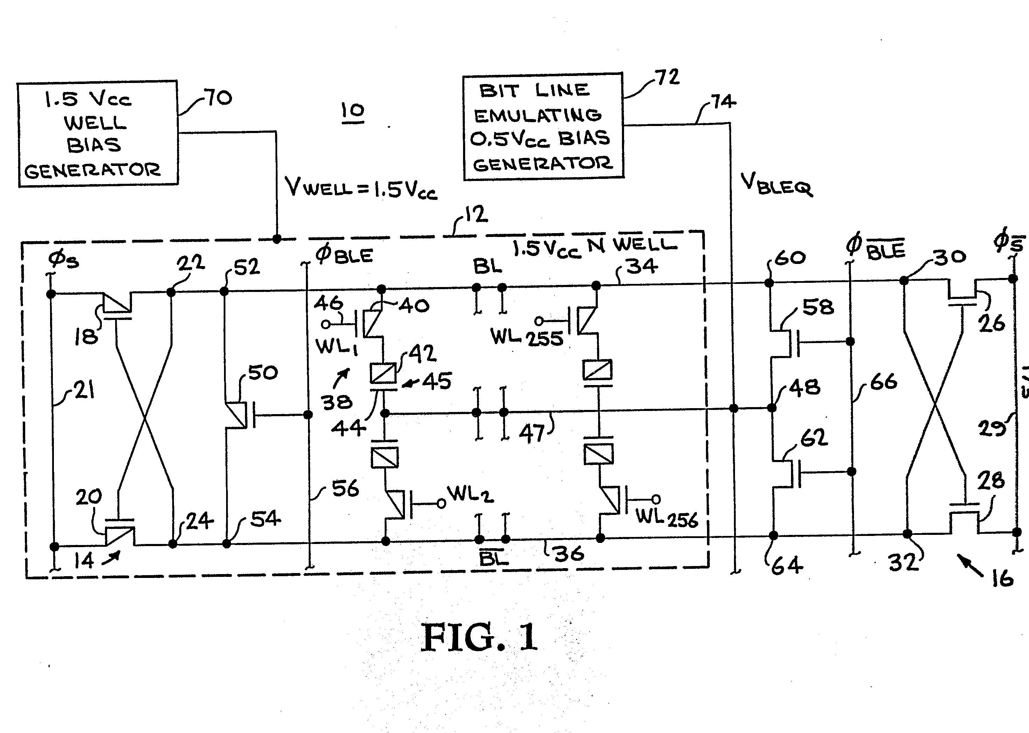

Fig. 1 is a schematic diagram of a preferred embodiment of the present invention. In Fig. 1 the circuit is configured on the surface 10 of a P doped silicon substrate. An N well 12 is formed on the surface of the P type substrate 13. A sense amp comprises a P channel cross-coupled latch 14 and an N channel cross-coupled latch 16. The P channel cross-coupled latch 14 includes first and second P channel transistors 18 and 20 having their sources tied to a P channel source drive line 21. The first P channel transistor 18 has its drain coupled to a first circuit node 22 with the gate of the second transistor 20 also coupled to the first circuit node 22. The drain of the second transistor 20 is coupled to a second circuit node 24 with the gate of the first transistor 18 coupled to the second node 24.

The N channel cross-coupled latch 16 includes third and fourth N channel transistors 26 and 28 having their sources tied to an N channel source drive line 29. The drain of the third transistor 26 is coupled to a third circuit node 30 with the gate of the fourth transistor 28 also coupled to the third circuit node 30. Similarly, the drain of the fourth transistor 28 is coupled to a fourth circuit node 32 with the gate of the third transistor 26 coupled to the fourth circuit node 32.

A bit line, 34, couples the first and third circuit nodes 22 and 30 and a dummy bit line, 36, couples the second and fourth circuit nodes 24 and 32.

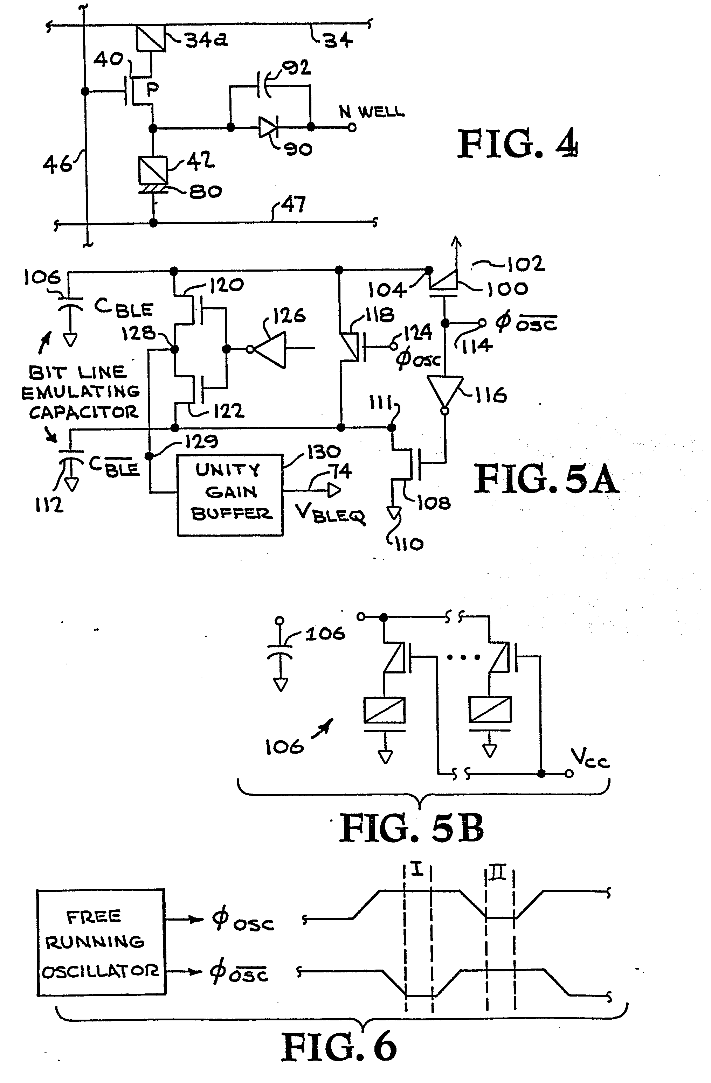

The bit line is coupled to a first set of 128 storage cells 38. These storage cells are described in more detail below with reference to Figs. 3 and 4. Each storage cell includes a transistor switched transfer gate 40 coupling a storage node 42 to the bit line 34. The storage node 42 and a capacitor plate 44 form a storage capacitor 45 having capacitance $C_{ST}$. The gates of the transistors in the transfer gates 40 are tied to a set of word lines 46.

The dummy bit line 36 is coupled to a second set of memory cells 38. The first and second sets of memory cells 38 are defined by alternating wordlines 46. It is to be understood that the terms bit line and dummy bit line are relative. The bit line is the line coupled to a memory cell during a read, write, or refresh operation.

For example, if the cell 38 accessed by $WL_1$ is read then line 34 is the bit line and line 36 is the dummy bit line. However, if the cell 38 accessed by $WL_2$ is read, then line 36 is the bit line and line 34 is the dummy bit line.

All the capacitor plates 44 are tied to a common CP line 47 which terminates at a fifth circuit node 48.

A fifth P channel coupling transistor 50 couples a sixth circuit node 52 on the bit line 34 to a seventh circuit node 54 on the dummy bit line 36. The gate of the fifth transistor 50 is coupled to a $\phi_{BLE}$ signal line 56. A sixth N channel biasing transistor 58 couples an eighth circuit node 60 on the bit line 34 to the fifth circuit node 48. A seventh N channel biasing transistor 62 couples a ninth circuit node 64, on the dummy bit line 36, to the fifth circuit node 48. The gates of the sixth and seventh transistors 58 and 62 are coupled to a $\phi_{\overline{BLE}}$ enable line 66.

A 1.5 $V_{CC}$ well bias generator 70 is coupled to the N well 12. A bit line emulating $V_{CC}/2$ bias generator 72 is coupled to the fifth node 48 by a $V_{BLEQ}$ line 74.

Typically, an actual array would include a large number of the circuits depicted in Fig. 1. The $V_{BLEQ}$ line 74 would be tied to all the circuits to assure that precharge level was the same throughout the array.

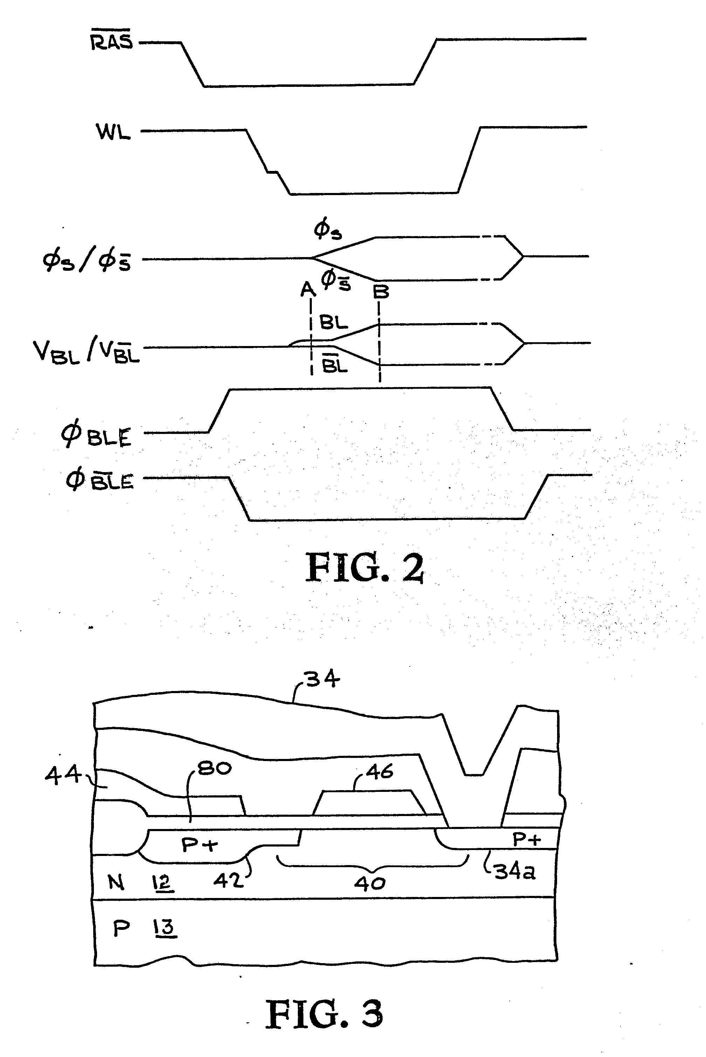

The functioning of the circuit depicted in Fig. 1 will now be described with reference to Fig. 2, which is a timing diagram calling out the voltage states on the word line, $V_{WL}$, the voltage levels on P channel and N channel source drive lines 29 and 21, $\phi_S$ and $\phi_{\overline{S}}$ respectively, the voltage levels on the bit line and dummy bit line 34 and 36, $V_{BL}$ and $V_{\overline{BL}}$, and the voltage levels on the $\phi_{BLE}$ and $\phi_{\overline{BLE}}$ lines 56 and 66. The voltage levels shown in the timing diagram illustrate a read "1" sense cycle.

Referring now to Figs. 1 and 2, the read "1" sense cycle is initiated by externally changing the magnitude of the $\overline{RAS}$ signal from a high state to a low state. In this example it is assumed that the storage element coupled to $WL_1$, storing the data element "1", is accessed.

A data element "1" is stored by charging the storage node 42 to a voltage level equal to $V_{CC}$. The capacitance of the storage capacitor 45 is equal to $C_{ST}$. Therefore, the charge on the storage node indicating a "1", $Q_{ST}(1)$, is equal to $C_{ST}V_{CC}$. When a 0 is stored, $Q_{ST}(0)$ is equal to zero.

Prior to the read sense cycle, $\overline{RAS}$ is high, $\phi_{BLE}$ is low, and $\phi_{\overline{BLE}}$ is high. Thus, prior to the read sense cycle the bit line and dummy bit line are coupled by the fifth transistor 50 and the series circuit comprising the sixth and seventh transistors 58 and 62. Additionally, the bit line and dummy bit lines are tied to the output of the $V_{CC}/2$ bias generator 72 by the sixth and seventh transistors 58 and 62. Accordingly, prior to the read sense cycle the bit line and dummy bit lines are precharged to $V_{CC}/2$. By precharging the bit line/dummy bit line pair prior to initiating the sense cycle the voltages on the lines are allowed to settle thereby reducing noise. The signals $\phi_S$ and $\phi_{\overline{S}}$ are also initialized to $V_{CC}/2$.

When the read sense cycle is initiated by clocking $\overline{RAS}$ low, $\phi_{BLE}$ is clocked high and $\phi_{\overline{BLE}}$ is clocked low. Accordingly, the coupling and biasing transistors 50, 58, and 62 are driven into the non-conducting state and the bit line 34 is electrically isolated from the dummy bit line 36 and the bias generator 72. $V_{WL}$ on $WL_1$ is pulled low to couple the storage node 44 to the bit line 34.

The charge on the bit line is increased by the quantity $Q_{ST}(1)$. Accordingly, the voltage on the bit line is slightly higher than the voltage on the dummy bit line as indicated at point A on the timing diagram. This voltage difference at point A is the differential sense amp voltage applied to the SA.

The source drive signals, $\phi_S$ and $\phi_{\overline{S}}$, are then applied to the P channel cross-coupled latch 14 and the N channel cross-coupled latch 16. The voltages at the first and third nodes 22 and 30 are equal to the value of $V_{BL}$ indicated at point A of the timing diagram. Similarly, the voltage levels at the second and fourth nodes 24 and 32 are equal to the value of $V_{\overline{BL}}$ indicated at point A of the timing diagrams. The cross-coupled P channel latch 14 is triggered by the voltage difference at point A of the timing diagram to pull the bit line 34 up to the full $V_{CC}$ value at point B. Similarly, the cross-coupled N channel latch 16 is triggered by the differential sense amp voltage indicated at point A to pull the dummy bit line 36 down to zero volts at point B of the timing diagram.

Precharging the bit lines and dummy bit lines 34 and 36 to $V_{CC}/2$ facilitates the simultaneous pull up and pull down of $V_{BL}$ and $V_{\overline{BL}}$ illustrated in the timing diagram.

At the completion of the read "1" sense cycle $\overline{RAS}$ is clocked high. Slightly thereafter, $\phi_{BLE}$ is clocked low, thereby coupling the bit line, 34, and the dummy bit line, 36 via the coupling transistor 50. The capacitance of bit line 34, $C_{BL}$, and of dummy bit line 36, $C_{\overline{BL}}$, are approximately equal. Note that prior to the coupling of the bit line 34 and the dummy bit line 36, $V_{BL}$ is $V_{CC}$ and $V_{\overline{BL}}$ is zero. Accordingly, when the lines are coupled the voltage levels on the bit line 34 and the dummy bit line 36, $V_C$, will be equal to the intermediate level between zero and $V_{CC}$, i.e., about $V_{CC}/2$.

Subsequent to the coupling of the bit line/dummy bit pair, $\phi_{\overline{BLE}}$ is clocked high to couple the bit line/dummy bit line pair to the $V_{BLEQ}$ output 74 via the coupling transistors 58 and 67.

The $\phi_{BLE}$ and $\phi_{\overline{BLE}}$ signals are clocked with reference to $\overline{RAS}$. The generation of the signals is accomplished by standard techniques well-known in the art.

Fig. 3 is a cross sectional view of a storage cell 38 utilized in the present embodiment. Identical or corresponding parts in Figs. 1 and 3 are given the same reference numeral. The bit line 34 is coupled to a P+ bit line junction 34A which forms a first terminal of the transistors in the transfer gates 40. The second terminal of the access transistor is the P+ region 42 which forms the storage node. The capacitor plate 44 is a polysilicon layer disposed over part of the storage node 42 and separated from the storage node by a thin oxide layer 80. The capacitance of the thin oxide layer 80 is equal to $C_{OX}$. The interface between the storage region 42 and the N well 12 forms a PN junction which acts as a diode. The PN junction has a capacitance equal to $C_J$.

Fig. 4 is a schematic diagram of the memory cell depicted in Fig. 3. The effects of a voltage bump on the magnitude of the charge, $Q_{ST}$, stored in the storage region 42 and the voltage at the storage node, $V_{ST}$, will now be described with reference to Fig. 4. In Fig. 4 the PN diode formed between the storage region 42 and the N well 12 and the inherent capacitance, $C_J$, of the PN junction is represented by a diode and a capacitor 90 and 92.

During a voltage bump, from, for example, $V_{CC}$ equals 6 volts to $V_{CC}$ equals 4 volts, the quantum of charge, $Q_{ST}$, stored in the storage region 42 will change due to capacitive coupling through the thin oxide layer 80 separating the capacitive plate from the storage region, and through the capacitance $C_J$ of the PN region formed between the storage region 42 and the N well 12. Additionally, the PN diode 90 may be forward biased, thereby allowing charge to be injected into the N well 12 from the storage region 42.

This changing of the charge level stored in the storage region 42 due to a voltage bump tends to reduce the magnitude of the differential sense voltage between bit line 34 and dummy bit line 36 generated during a read operation. Any reduction in the magnitude of this differential sense voltage greatly reduces the efficiency of the sense amp and causes errors in the reading of the stored bits of the memory. The inventors have discovered that biasing the capacitor plates in the array at $V_{CC}/2$ stabilizes the magnitude of the differential sense amp voltage against $V_{CC}$ bumps.

A further problem associated with voltage bumps is the disturbance of the sense level on the bit line due to charge coupling between unselected stored "1"s and the bit line 34. This sense disturbance will be illustrated by the following example, where the voltage level values given merely serve to illustrate the principles involved and are not intended to be the values achieved in an actual circuit.

Assume that $V_{CC}$ bumps from 6 volts to 4 volts and, since the word line 46 is tied to $V_{CC}$, that the voltage at the gate of the transistors in the transfer gates 40 drops from 6 volts to 4 volts. The source voltage of the transistors in the transfer gates 40 is equal to $V_{ST}$. The charge stored at the storage node was set by charging the storage capacitor 45 when $V_{CC}$ was equal to 6 volts and, accordingly, $V_{ST}$, is equal to 6 volts. If the capacitor plate is tied to ground and the N well is biased at 1.5 $V_{CC}$, then the voltage level at the storage node will drop from 6 volts to about 5.4 volts during the $V_{CC}$ bump. The storage node is the source of the transistors in the transfer gates 40 and, accordingly, $V_{GS}$, which is equal to the gate voltage minus the source voltage, is equal to -1.4 volts. Since the threshold voltage of a P channel transistor is equal to about -.7 volts, the access transistor will be turned on and current will flow from the storage region to the bit line, thereby changing $V_{BL}$ prior to the sense operation.

However, if the capacitor plate is tied to the supply voltage, or some multiple thereof, the sense disturb problem is reduced or eliminated. In the present invention, both sense disturb and prevention of differential sense voltage reduction are achieved by setting $V_{CP}$ equal to $V_{CC}/2$.

Additionally, charge injection due to reverse biasing the PN diode between the storage region and the N well is prevented because $V_{NW}$ is equal to 1.5 $V_{CC}$. If $V_{CC}$ bumps from 6V to 4V the value of $V_{NW}$ is 6V and the diode 92 remains reverse-biased.

Fig. 5 is a circuit diagram of the bit line emulating $V_{CC}/2$ bias generator 72 of Fig. 1. Referring now to Fig. 5, a P channel transistor 100 couples a $V_{CC}$ input 102 to a circuit node 104. The circuit node 104 is coupled to a bit line emulating capacitor, $C_{BLE}$ 106. An N channel transistor 108 couples a ground terminal 110 to a circuit node 111. The circuit node 111 is coupled to a dummy bit line emulating capacitor, $C_{\overline{BLE}}$ 112. The gate of transistor 100 is directly coupled to a $\phi_{\overline{OSC}}$ input 114, while the gate of transistor 108 is coupled to the $\phi_{\overline{OSC}}$ input 114 through an inverter 116. The capacitors $C_{BLE}$ and $C_{\overline{BLE}}$ are coupled by a P channel transistor 118 and a series circuit comprising N channel transistors 120 and 122. The gate of transistor 118 is directly coupled to a $\phi_{OSC}$ input 124 and the gates of transistors 120 and 122 are coupled to the $\phi_{OSC}$ input 124 via an inverter 126. The source of tran-

14

sistor 120 and drain of transistor 122 are coupled to a circuit node 128. Circuit node 128 is coupled to the input of a unity gain buffer circuit 130 having an output providing a $V_{BLEQ}$ signal on the $V_{BLEQ}$ line 74.

The circuit elements of the bit line emulating bias voltage generator 72 depicted in Fig. 5A correspond to the circuit elements depicted in Fig. 1. In particular, $C_{BLE}$ and $C_{\overline{BLE}}$ 106 and 112 correspond to the capacitance of bit lines 34, dummy bit lines 36, and transfer gates 40 in the array, transistors 102 and 110 correspond to the transistors in the cross-coupled latches 14 and 16; transistor 118 corresponds to the fifth coupling transistor 50; and transistors 120 and 122 correspond to the sixth and seventh coupling transistors 58 and 62. Each of the circuit elements of the bit line emulating bias generator 72 are fabricated to emulate the characteristics of the corresponding elements in the circuit depicted in Fig. 1.

Fig. 5B depicts the structure of $C_{BLE}$ and $C_{\overline{BLE}}$. Thus, both $C_{BLE}$ and $C_{\overline{BLE}}$ closely emulate the total capacitance of the memory cells 38 of Fig. 1.

The operation of the circuit depicted in Fig. 5 will now be described with reference to the timing diagram of Fig. 6. In Fig. 6 the states of $\phi_{OSC}$ and $\phi_{\overline{OSC}}$ are depicted as a function of time. During time interval "I" $\phi_{OSC}$ is clocked high to turn off transistors 118, 120, and 122 and to electrically isolate $C_{BLE}$ and $C_{\overline{BLE}}$ 106 and 112. During this time interval $\phi_{\overline{OSC}}$ is clocked low to turn on transistor 102 and charge capacitor $C_{BLE}$ 106 to $V_{CC}$ while transistor 108 is also turned on to charge capacitor $C_{\overline{BLE}}$ 112 to zero volts. Accordingly, during time interval "I" $C_{BLE}$ 106 is charged to $V_{CC}$ and $C_{\overline{BLE}}$ 112 is charged to zero.

During time interval "II" $\phi_{\overline{OSC}}$ is clocked high to turn off transistors 100 and 108, thereby isolating $C_{BLE}$ and $C_{\overline{BLE}}$ 106 and 112 from the $V_{CC}$ and ground terminals 102 and 110, respectively. The signal $\phi_{OSC}$

is clocked low to turn on transistors 118, 120, and 122 to couple $C_{BLE}$ 106 to $C_{\overline{BLE}}$ 112. In this embodiment, the magnitudes of $C_{BLE}$ and $C_{\overline{BLE}}$ 106 and 112 are equal so that the above-described coupling step allows charge to distribute equally between the two capacitors and so that the voltage on both capacitors is equal to about $V_{CC}/2$.

The capacitors 106 and 112 are coupled to output terminal 129 during time interval "II." The magnitude of the output signal, $V_{BLE}$ at the output terminal 129 is thus determined by charge sharing between $C_{BLE}$ and $C_{\overline{BLE}}$ 106 and 112.

The output terminal 129 is coupled to the input of the unity gain buffer 130. The output of the unity gain buffer 130, $V_{BLEQ}$, is thus equal to about $V_{CC}/2$.

The magnitude of the output voltage, $V_{BLEQ}$, closely tracks the magnitude of the voltage level, $V_C$, generated by coupling the bit line 34 and dummy bit line 36, due to the emulation of corresponding circuit elements. The importance of this tracking is illustrated by the following example.

It is well-known that the output of any voltage reference is affected by temperature, and undesired variations in circuit parameters. Accordingly, while $V_C$ and $V_{BLEQ}$ are nominally equal to $V_{CC}/2$, minor deviations will be induced by the above-described factors.

Referring back to Fig. 1, assume that $V_{CC}$ is 5 volts and that the voltage developed by coupling the bit line 34 and dummy bit line 36, $V_C$, developed at node 48 is 2.2 volts due to variations in processing parameters. Further, assume that $V_{BLEQ}$ is 2.5 volts. Thus, the bit line emulating bias generator must charge the bit line/dummy line pairs in the array to 2.5 volts by supplying current. The generation of charging current dissipates power and is deleterious to the overall performance of the memory array.

In contrast, in the present invention $V_C$ and $V_{BLEQ}$ are nearly equal due to the emulation of circuit components. Very little current is required to charge the bit line/dummy bit line pair and, thus, minimal power is dissipated.

The bit line emulating bias voltage generator 72 supplies current to the bit line/dummy bit line pair to compensate for leakage current through the bit line junctions during the long precharge cycle. Additionally, it maintains a reference voltage level during a $V_{CC}$ bump to prevent signal loss and biases the capacitor plates in the memory cells.

Thus, the buffer 130 must have a current source/sink capability to perform these functions. A low power CMOS reference voltage driver suitable for use in the present system is described in a copending, commonly assigned, patent application by Chuang, et al., entitled "Low Power CMOS Reference Generator with Low Impedance Driver," Attorney-Docket No. A298, which is hereby incorporated by reference. This buffer has the current source/sink capability to maintain all CPs at $V_{CC}/2$ and to maintain the bit line and dummy bit line pair precharge level at $V_{CC}/2$.

Thus, the biasing scheme of the present invention reduces, or eliminates, the problems of precharge current spike, the reduction of the differential sense voltage signal, the problems of sense disturbance and charge injection. Additionally, precharging the bit line/dummy bit line pair prior to initiating the sense cycle keeps the access time at a minimum. The emulation technique utilized in the voltage reference minimizes power dissipation.

The invention has been explained with reference to specific embodiments. Other embodiments will now be apparent to those of ordinary skill in this art. In particular, the arrangement of the bit lines, memory cells, and other circuit components is not critical to practicing the invention. Further, small deviations from the exemplary bias voltage levels set forth may not be significant in particular applications.

Additionally, the bias scheme of the present invention is suitable for use in a CMOS memory having N channel memory cells disposed in a P well formed in an N type substrate.

Accordingly, it is therefore not intended that the invention be limited except as indicated by the appended claims.

CLAIMS

1.    A CMOS memory bias system, where said CMOS memory is coupled to an external power supply voltage source, $V_{CC}$, and is of the type including a plurality of memory cells and dummy memory cells having channels of a first conductivity type disposed in a well of a second conductivity type formed in a substrate of the first conductivity type, said system comprising:

a CMOS sense amp for sensing a bit stored in said memory cell during a sense cycle;

a bit line coupled to a first input of said sense amp;

a dummy bit line coupled to a second input of said sense amp;

at least one memory cell having gate coupling a storage capacitor to said bit line, with said storage capacitor including a storage node and a capacitor plate;

means for coupling said bit line and said dummy bit line to precharge said bit line/dummy bit line pair to about $V_{CC}/2$; and

means for biasing said coupled bit line and dummy bit line and said capacitor plate to a multiple of $V_{CC}$.

2.    The system    of claim 1 wherein the memory cells have P type transfer gates, the well is an N well, and the substrate is of P type silicon.

3.    The system    of claim 2 further comprising:

means for activating said means for coupling and said means for biasing prior to the initiation of said sense cycle.

4.    The  system  . of claim 3 wherein said means for biasing said capacitor plates and dummy capacitor plates comprises:

a bit line emulating bias generator for generating a $V_{BLEQ}$ output signal having a magnitude equal to about $V_{CC}/2$.

5.    The .system    of claim 4 further comprising:

means for coupling said bit line and said dummy bit line to the output of said bit line emulating bias generator.

6.    The  system    of claim 5 further comprising:

means for biasing the well at about 1.5 $V_{CC}$.

7. . The  system . of claim 5 wherein said means for coupling comprises:

a coupling transistor, activated by clocking a $\phi_{BLE}$ coupling signal from a first state to a second state, for selectively coupling said bit line and said dummy bit line.

8.    The  system    of claim 7 wherein said means for biasing comprises:

a first biasing transistor, activated by clocking a $\phi_{\overline{BLE}}$ signal from a first state to a second state, for coupling said bit line to said $V_{BLEQ}$ output signal; and

a second biasing transistor, activated by clocking the $\phi_{\overline{BLE}}$ signal from the first to the second state, for coupling said dummy bit line to said $V_{BLEQ}$ output signal.

9. The system of claim 8 wherein said means for coupling further comprises:

means for changing the state of the $\phi_{BLE}$ signal prior to the initiation of said sense cycle.

10. The system of claim 9 wherein said means for biasing further comprises:

means for changing the state of the $\phi_{\overline{BLE}}$ signal prior to the initiation of said sense cycle.

11. The system of claim 10 wherein said bit line emulating bias generator comprises:

means for emulating the characteristics of said bit line, said dummy bit line, and transfer gates;

means for emulating the characteristics of said CMOS sense amp;

means for emulating the characteristics of said coupling transistor; and

means for emulating the characteristics of said biasing transistors.

12. The system of claim 11 wherein said sense amp comprises:

a cross-coupled P channel latch coupling said bit line and said dummy bit line; and

a cross-coupled N channel latch coupling said bit line and said dummy bit line.

13. A bias system for a CMOS memory array coupled to an external voltage supply, $V_{CC}$, said memory of the type having a CMOS sense amp coupled to a bit line and a dummy bit line, with the said amp for sensing a bit stored in the memory cell during a sense cycle with the bit line connected to a set of memory cells, each having a transfer gate of a first conductivity type for coupling a storage capacitor to the bit line with the storage capacitor having a storage node and a capacitor plate, and with the memory cells disposed in a well of a second conductivity type formed in a substrate of the first conductivity type, said system comprising:

means for coupling said bit line and dummy bit line to precharge the lines to $V_C$, where $V_C$ is about equal to $V_{CC}/2$; and

means for biasing the precharged bit line and dummy bit line and capacitor plates to about $V_{CC}/2$.

14.    The  system   of claim 13 wherein said means for biasing comprises:

a bit line emulating bias generator for providing a $V_{BLEQ}$ output where $V_{BLEQ}$ is substantially equal to $V_C$.

15.    The  system   of claim 14 further comprising:

means for biasing the well at about 1.5 $V_{CC}$.

16.    The  system   of claim 15 further comprising:

means for activating said precharging means prior to the initiation of said sense cycle.

17.    A system for biasing a CMOS memory array connected to an external voltage supply, $V_{CC}$, with the array formed on a substrate of a first conductivity type, said array of the type having at least one sense amp for sensing a differential voltage signal, developed at first and second input nodes of the sense amp, during an externally initiated sense cycle and said array of the type having a plurality of memory cells, each cell having a storage capacitor, including a capacitor plate and a storage node, and also having a transfer gate of a first conductivity type, with the memory cells disposed in a well of a second conductivity type formed in the substrate, said system comprising:

a bit line coupled to the first input node of the sense amp;

a first set of memory cells controllably coupled to said bit line;

a dummy bit line coupled to the second input node of said sense amp;

a second set of memory cells controllably coupled to said dummy bit line;

a coupling transistor, activated by clocking a $\phi_{BLE}$ signal from a first state to a second state, for selectively coupling said bit line and said dummy bit line, where the magnitude of the voltage level developed on the bit line and dummy bit line after coupling is $V_C$;

a bit line emulating voltage bias generator for generating a $V_{BLEQ}$ output signal;

first and second biasing transistors, activated by clocking a $\phi_{\overline{BLE}}$ signal from a first state to a second state, for selectively coupling said bit line and dummy but line, respectively, to said $V_{BLEQ}$ signal, with said bit line emulating bias generator including circuit elements for emulating the characteristics of said sense amp, bit line, dummy bit line, coupling transistor, and biasing transistors so that the magnitude of $V_{BLEQ}$ is substantially equal to $V_C$, with $V_{BLEQ}$ and $V_C$ equal to about $V_{CC}/2$;

a CP line for coupling the capacitor plates of the memory cells in said first and second sets to said $V_{BLEQ}$ output signal;

means for biasing the well at about 1.5 $V_{CC}$; and

means for clocking $\phi_{BLE}$ and $\phi_{\overline{BLE}}$ to said second state prior to the initialization of said sense cycle.

18. The system of claim 17 having a P type substrate, an N type well, and P type transfer gates.

FIG. 1

FIG. 2

FIG. 3

3/3

0200500

FIG. 4

FIG. 5A

BIT LINE EMULATING CAPACITOR

$C_{BLE}$

$C_{\overline{BLE}}$

UNITY GAIN BUFFER

$V_{BLEQ}$

$\phi_{OSC}$

$\phi_{\overline{OSC}}$

FIG. 5B

$V_{CC}$

FREE RUNNING OSCILLATOR

$\phi_{OSC}$

$\phi_{\overline{OSC}}$

FIG. 6